Europäisches Patentamt

European Patent Office

Office européen des brevets

(11) Veröffentlichungsnummer : **0 095 196 B1**

# (12) EUROPÄISCHE PATENTSCHRIFT

(45) Veröffentlichungstag der Patentschrift :
12.11.86

(21) Anmeldenummer : 83200497.2

(22) Anmeldetag : 08.04.83

(51) Int. Cl.⁴ : **F 16 C 27/00, F 01 D 25/16**

(54) **Federnde Stützeinrichtung für Wellenlager von schnelllaufenden Rotoren, insbesondere von Turbomaschinen.**

(30) Priorität : 26.05.82 CH 3223/82

(43) Veröffentlichungstag der Anmeldung :
30.11.83 Patentblatt 83/48

(45) Bekanntmachung des Hinweises auf die Patenterteilung : 12.11.86 Patentblatt 86/46

(84) Benannte Vertragsstaaten :
**CH DE FR GB LI**

(56) Entgegenhaltungen :
**EP-A- 0 064 251**
**FR-A-    672 657**
**FR-A- 1 516 642**
**GB-A-    205 655**
**US-A- 3 485 538**
**US-A- 3 653 731**

(73) Patentinhaber : **BBC Aktiengesellschaft Brown, Boveri & Cie.**
**Haselstrasse**
**CH-5401 Baden (CH)**

(72) Erfinder : **Hörler, Hansulrich, Dr.**
**Lerchenberg 5**
**CH-8046 Zürich (CH)**
Erfinder : **Koller, Rudolf**
**Sagenbachmatt 2**
**CH-6280 Hochdorf (DE)**

## Beschreibung

Die vorliegende Erfindung betrifft eine federnde Stützeinrichtung für Wellenlager von schnellaufenden Rotoren, insbesondere von Turbomaschinen, nach dem Oberbegriff des Patentanspruchs 1.

Bei schnelläufigen kleineren Turbomaschinen, insbesondere bei Turboladern mit ihren extrem hohen Drehzahlen, ist es erforderlich, die auf die Lagerung der Rotoren einwirkenden dynamischen Betriebskräfte, das sind Kräfte durch Vibrationen des Verbrennungsmotors und durch eventuelle Unwuchten, durch zwischen der Lagerung und dem Gehäuse vorgesehene federnde und dämpfende Elemente abzuschwächen, wobei die federnden und die dämpfenden Elemente voneinander getrennt oder miteinander kombiniert sein können. Die vorliegende Erfindung betrifft aber lediglich die federnden Elemente der Lagerstützeinrichtung.

Bekannt sind für diesen Zweck federnde, aus gewellten konzentrischen Blechhülsen zusammengesetzte Ringfederpakete, die aber wegen ihrer stark progressiven Federkennlinie vor allem für grosse Turbolader nicht optimal sind, da hierbei schon durch das Rotorgewicht ein unzulässig grosser Teil des Federweges geopfert wird. Die Reibung zwischen den einzelnen Blechhülsen sorgt dabei zwar einerseits für eine gewisse, erwünschte Dämpfung, doch sind damit andererseits auch unerwünschte Verschleisserscheinungen verbunden.

Aus dem Flugtriebwerksbau sind auch stabförmige Lagerstützeinrichtungen bekannt, bei denen zwischen Lager und Gehäuse über den Lagerumfang verteilt lange achsiale, federnde Stäbe vorhanden sind, deren eines Ende am Gehäuse und deren anderes Ende an einer Lagerhülse, die den Kugellageraussenring aufnimmt, verankert ist. Dadurch üben diese Stäbe bei Querversetzungen des Lagers ein Moment auf das Gehäuse aus. Diese Bauart benötigt ausserdem verhältnismässig viel achsialen Einbauraum, wodurch sie sich für kleinere Turbomaschinen, insbesondere für Turbolader, nicht ideal eignet.

Beispiele für diese Bauart sind in der EP-A-0 064 251 und in der FR-A-672 567 beschrieben. Beim erstgenannten Dokument, das zum Stand der Technik nach Artikel 54 (3) EPÜ gehört, handelt es sich um Stützeinrichtungen mit einem oder mehreren Kränzen einseitig eingespannter Biegefederstäbe von Rechteckquerschnitt, die um das Lager herum gleichmässig verteilt in einem ölgefüllten, geschlossenen Gehäuse angeordnet sind. Bei Schwingungsausschlägen des Lagers wirkt das zwischen den einzelnen Reihen der Biegefederstäbe und der dazwischen vorhandenen Stützflanschen befindliche Oel als Dämpfungsflüssigkeit.

Die FR-A-672 567, das zweite erwähnte Dokument, betrifft eine Stützeinrichtung mit einem einzigen Kranz von Biegefederstäben, deren eines Ende jeweils mit dem einen Ende einer geschlossenen Lagerhülse, die ein Wälzlager aufnimmt, starr verbunden ist.

Neben den obenerwähnten Nachteilen bekannter elastischer Stützeinrichtungen haftet diesen zwei bekannten Bauarten der Nachteil an, dass bei Schwingungsausschlägen sich der Spalt zwischen benachbarten Kränzen von Biegefederstäben bzw. zwischen diesen und der Lagerhülse oder einem sonstigen Flansch keilförmig verengt, so dass die Spalthöhe nur teilweise ausgenützt werden kann. Auch stellt die einseitige Einspannung der Biegefederstäbe einen ungünstigen Belastungsfall dar. Dies ist ein Nachteil, der vor allem mit der vorliegenden Erfindung vermieden werden soll. Die erfindungsgemässe Stützeinrichtung soll mit geringeren Materialquerschnitten und Einbaumassen, insbesondere in radialer Richtung, auszuführen sein als eine solche bekannter Bauart von gleicher Federsteife.

Mit der vorliegenden, im kennzeichnenden Teil des Patentanspruchs 1 definierten Erfindung sollen die Nachteile der erwähnten bekannten Lagerstützeinrichtungen vermieden werden. Insbesondere soll sie eine Momentenrückwirkung auf das Lager vermeiden und sich für kleine Turbomaschinen, zu denen auch grosse Turbolader zu zählen sind, eignen, indem sich eine solche Abstützung platzsparend im Gehäuse unterbringen lässt.

Im folgenden wird die Erfindung unter Bezug auf in der Zeichnung dargestellte Ausführungsbeispiele der Erfindung näher beschrieben. In der Zeichnung stellen dar:

Figur 1 im Längsschnitt einen Ausschnitt aus einer erfindungsgemässen Wellenlagerung für einen Turboladerrotor,

Figur 2 eine zu Fig. 1 gehörige Seitenansicht, und die

Figur 3 und 4 eine zweite Ausführungsform einer erfindungsgemässen Wellenlagerung im Längsschnitt und in der Seitenansicht.

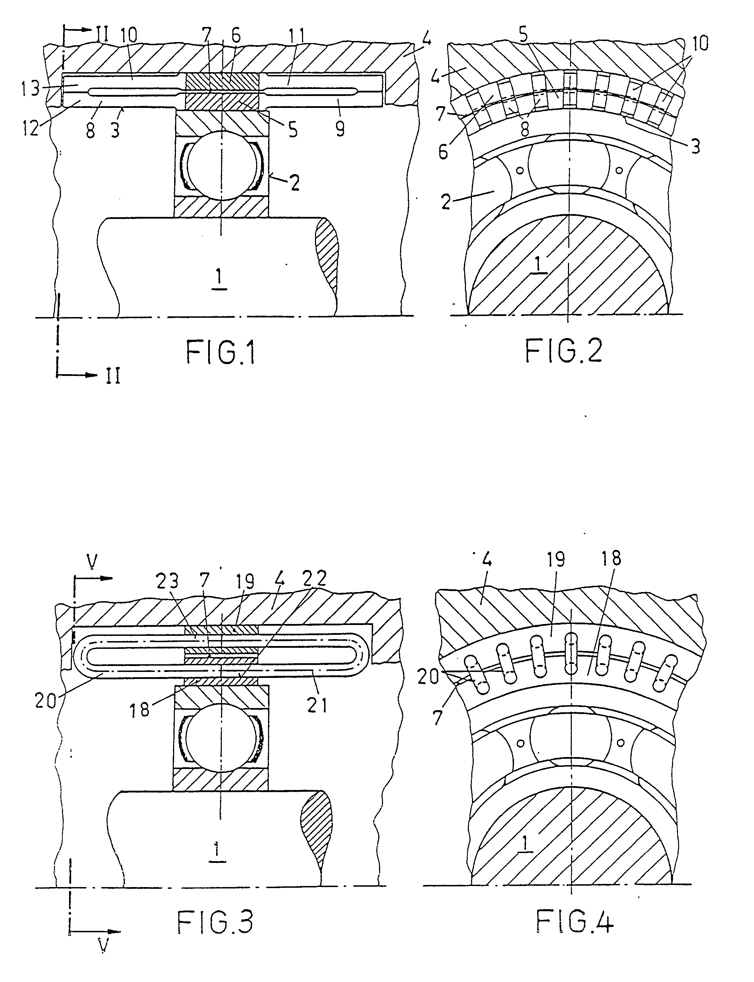

Bei der Ausführung nach den Fig. 1 und 2 ist eine Welle 1 des Turboladerrotors mit einem Rillenkugellager 2 unter Vermittlung einer vorteilhaften Ausführungsform der erfindungsgemässen Stützeinrichtung 3 im Gehäuse 4 des Turboladers gelagert. Die zwischen dem Aussenring des Lagers 2 und einer Bohrung des Gehäuses 4 eingespannte Stützeinrichtung 3 weist eine innere Bandage 5 und eine äussere Bandage 6 auf, zwischen denen ein Spalt 7 besteht, der eine über den ganzen Umfang konstante, radiale Breite aufweist. Die beiden Bandagen 5 und 6 sitzen mit leichter Presspassung auf dem Aussenlaufring des Kugellagers 2 bzw. im Gehäuse 4. An den beiden Stirnseiten der beiden Bandagen 5 und 6 erstrecken sich, über den ganzen Umfang gleichmässig verteilt, senkrecht zur Ebene der Stirnflächen innere Biegefederstäbe 8, 9 bzw. äussere Biegefederstäbe 10, 11, die entweder mit der respektiven Bandage aus einem Stück gefertigt oder als getrennt hergestellte Teile mit der betreffenden Bandagenstirnfläche, beispielsweise durch Elektronenstrahlschweissen, verbunden sein können. Die freien Enden je zweier einander zugeordneter Biegefederstäbe 8 bis 11 können ebenfalls miteinander verschweisst sein, es ist aber auch möglich, sie mittels Nieten, Passstiften oder Schrauben zu verbinden.

In Fig. 1 sind die zwei zusammenwirkenden freien Enden der Biegefederstäbe 8 und 10 mit 12 bzw. 13 bezeichnet. Die radiale Breite des Luftspaltes 7 entspricht dem maximal möglichen Ausschlag des Lagers 2 bzw. der Welle 1 an der Lagerstelle aus ihrer Mittellage heraus quer zur Wellenachse als Folge der eingangs erwähnten Störkräfte. Im Gehäuse 4 ist zu beiden Seiten der Bandagen 5 und 6 so viel freier Raum vorzusehen, dass die Verformung der Biegefederstäbe nicht behindert wird.

In Fig. 1 ist zur Erhöhung der Uebersichtlichkeit von den Biegefederstäben jeweils nur das oberste im Scheitel der Stützeinrichtung befindliche Paar gezeichnet.

Dasselbe gilt auch bezüglich der Fig. 3 für die Darstellung einer weiteren Ausführungsform, deren Seitenansicht die Fig. 4 zeigt. Bei dieser Variante bestehen die federnden Elemente aus zwei haarnadelförmigen Biegefederstäben 20 und 21, deren zwei Schenkel mit strenger Presspassung in Bohrungen 22 bzw. 23 in der inneren Bandage 18 bzw. äusseren Bandage 19 sitzen.

Der Einfachheit halber wurden die Stützeinrichtungen in direktem Kontakt mit dem Kugellageraussenring dargestellt. Praktisch wird aber die Stützeinrichtung mit einer Büchse kombiniert werden, die das Kugellager und/oder auch andere Wälzlager aufnimmt.

**Patentansprüche**

1. Federnde Stützeinrichtung für Wellenlager von schnelllaufenden Rotoren, insbesondere von Turbomaschinen, welche Stützeinrichtung dazu bestimmt ist, vom Rotor auf das Wellenlager quer zur Rotorwellenachse einwirkende Kräfte federnd aufzunehmen, mit einer inneren kreisringzylindrischen Bandage (5 ; 18), einer äusseren kreisringzylindrischen Bandage (6 ; 19), mit einer Mehrzahl von gleichmässig über den Umfang der beiden genannten Bandagen verteilt angeordneten Biegefederstäben (8-11 ; 20 + 21), die sich parallel zur gemeinsamen Längsachse der beiden Bandagen erstrecken und mit der inneren und der äusseren Bandage verbunden sind, wobei die Biegefederstäbe so geformt sind, dass zwischen den beiden Bandagen ein ringförmiger Spalt (7) vorhanden ist, dadurch gekennzeichnet, dass die Biegefederstäbe (8-11 ; 20 + 21) zu beiden Seiten der inneren und äusseren Bandagen (5, 18 bzw. 6, 19) angeordnet sind und sich von deren Stirnseiten aus symmetrisch nach beiden Seiten hin erstrecken.

2. Federnde Stützeinrichtung nach Anspruch 1, dadurch gekennzeichnet, dass die Biegefederstäbe (8 + 9 ; 10 + 11) rechteckigen oder quadratischen Querschnitt aufweisen und mit ihren jeweiligen Bandagen (5 bzw. 6) aus einem Stück bestehen, dass ihre freien Enden (12, 13) verdickt sind, dass sich je zwei einander gegenüberliegende Biegefederstäbe (8, 10 ; 9, 11) der beiden Bandagen (5, 6) mit ihren freien Enden gegenseitig aufeinander abstützen, und dass die einander gegenüberliegenden Biegefederstäbe (8, 10 ; 9, 11) an ihren freien Ende starr miteinander verbunden sind.

3. Federnde Stützeinrichtung nach Anspruch 1, dadurch gekennzeichnet, dass die Biegefederstäbe (20, 21) Kreisquerschnitt aufweisen und haarnadelförmig gebogen sind, und dass ihre parallelen Schenkel in Bohrungen (22, 23) in der inneren Bandage (18) bzw. äusseren Bandage (19) eingepresst sind.

**Claims**

1. Sprung support device for shaft bearings of high speed rotors, especially for turbo-machines, which support device is intended to provide sprung acceptance of forces from the rotor acting on the shaft bearing transversely to the axis of the rotor shaft, having an inner circular cylindrical collar (5 ; 18), an outer circular cylindrical collar (6 ; 19), having a multiplicity of bending spring rods (8-11 ; 20 + 21) evenly distributed around the periphery of the two said collars, which bending spring rods extend parallel to the common longitudinal axis of the two collars and are connected to the inner and outer collars, the bending spring rods being so shaped that an annular gap (7) is present between the two collars, characterised in that the bending spring rods (8-11 ; 20 + 21) are located on both sides of the inner and outer collars (5, 18 and 6, 19) and extend symmetrically on both sides from their end faces.

2. Sprung support device according to Claim 1, characterised in that the bending spring rods (8 + 9 ; 10 + 11) have rectangular or quadratic cross-sections and are integral with their collars (5 and 6), that their free ends (12, 13) are thickened, that each pair of mutually opposite bending spring rods (8, 10 ; 9, 11) of the two collars (5, 6) mutually support one another at their free ends and that the opposite bending spring rods (8, 10 ; 9, 11) are rigidly connected to one another at their free end.

3. Sprung support device according to Claim 1, characterised in that the bending spring rods (20, 21) have a circular cross-section and are bent to a hairpin shape and that their parallel arms are pressed into holes (22, 23) in the inner collar (18) and outer collar (19) respectively.

**Revendications**

1. Dispositif de support élastique pour des paliers d'arbres de rotors tournant à grande vitesse, en particulier de turbomachines, qui est destiné à absorber élastiquement des forces agissant à partir du rotor sur le palier d'arbre perpendiculairement à l'axe de l'arbre du rotor, comportant un anneau cylindrique intérieur en forme de couronne (5, 18), un anneau cylindrique extérieur en forme de couronne (6, 19) et plusieurs barreaux élastiques en flexion (8 à 11 ; 20, 21) uniformément répartis sur la périphérie des deux anneaux, qui s'étendent parallèlement à l'axe longitudinal commun des deux anneaux et qui sont reliés respectivement à l'anneau intérieur et à l'anneau extérieur, les barreaux élastiques en flexion étant façonnés d'une manière telle qu'entre les deux anneaux soit présent un interstice annulaire (7), caractérisé en ce que les barreaux élastiques en flexion (8 à 11 ; 20, 21) sont disposés de part et d'autre des anneaux intérieur et extérieur (5, 18 et 6, 19) et s'étendent depuis les faces d'about de ces anneaux symétriquement des deux côtés.

2. Dispositif de support élastique suivant la revendication 1, caractérisé en ce que les barreaux élastiques en flexion (8, 9 ; 10, 11) présentent une section rectangulaire ou carrée et sont d'une pièce avec leurs anneaux respectifs (5 et 6), leurs extrémités libres (12, 13) sont épaissies, deux barreaux élastiques en flexion des deux anneaux (5, 6) qui sont chaque fois opposés l'un à l'autre (8, 10 ; 9, 11) prennent appui l'un sur l'autre par leurs extrémités libres et les barreaux élastiques en flexion opposés (8, 10 ; 9, 11) sont reliés rigidement l'un à l'autre à leurs extrémités libres.

3. Dispositif de support élastique suivant la revendication 1, caractérisé en ce que les barreaux élastiques en flexion (20, 21) présentent une section circulaire et sont coudés en forme d'épingle à cheveux et leurs branches parallèles sont pressées dans des forures (22, 23) prévues dans l'anneau intérieur (18) et dans l'anneau extérieur (19).

FIG.1

FIG.2

FIG.3

FIG.4